# DEMANDE DE BREVET EUROPEEN

(11) **EP 0 700 084 A1**
(43) Date de publication de la demande: **06.03.1996**
(21) Numéro de dépôt: 95202282.0
(22) Date de dépôt: 23.08.1995
(51) Int. Cl.: H01L 23/40

(54) **Dispositif de fixation de composants électroniques de puissance contre un dissipateur et procédé de montage sur un circuit imprimé**

(30) Priorité: 02.09.1994 FR 9410584
(71) Demandeur: T.R.T. TELECOMMUNICATIONS RADIOELECTRIQUES ET TELEPHONIQUES, F-75013 Paris (FR); Philips Electronics N.V., NL-5621 BA Eindhoven (NL)
(72) Inventeur: Puyenchet, Jean-Claude, F-75008 Paris (FR)
(74) Mandataire: Pyronnet, Jacques

(57) **Abrégé**

Le dispositif comporte au moins un composant de puissance (51, 52, 53), un dissipateur (3) et une agrafe (4) pour leur solidarisation, sur au moins un support isolant (9). Selon l'invention, le (chaque) composant est muni d'un support particulier (9) et le (chaque) support comporte trois moyens de support et de positionnement : l'un (21), médian, pour le composant, le deuxième (24) pour le dissipateur, du côté métallique du composant, le troisième (25, 26) pour une extrémité de l'agrafe, du côté opposé. L'autre extrémité de l'agrafe comporte un crochet (14) à accrocher à la partie haute du dissipateur, de façon à établir un contact à pression entre le corps de l'agrafe, le composant, et le dissipateur.

Application au montage de composants de puissance sur une carte de circuit imprimé.

## Description

La présente invention concerne un dispositif de fixation de composants électroniques de puissance contre un dissipateur thermique comportant l'ensemble constitué par au moins un composant de puissance, un dissipateur et une agrafe élastique de fixation à pression du composant contre le dissipateur, cette agrafe ayant même orientation longitudinale que ledit composant, et au moins un support isolant dudit ensemble.

L'invention concerne aussi un procédé de montage d'un tel dispositif sur une carte de circuit imprimé.

A ce jour, il existe plusieurs types de fixation pour permettre une bonne dissipation thermique des composants de puissance montés sur dissipateur.

Un premier montage consiste à presser l'un contre l'autre (avec interposition d'un isolant électrique mais bon conducteur thermique), la partie métallique du composant contre le dissipateur au moyen de vis, écrou, rondelle et canon isolant, un trou standard étant d'ailleurs prévu à cet effet dans la partie métallique libre du composant. Cette technique impose d'effectuer un montage préalable des composants sur le dissipateur, ce qui nécessite l'utilisation d'un calibre de montage pour bien positionner les composants et, malgré cette mesure de positionnement, il apparaît une difficulté d'assemblage du dissipateur généralement équipé de plusieurs composants sur la carte électronique de circuit imprimé, due au fait qu'il faut enficher simultanément un assez grand nombre de broches dans des trous de la carte. De plus, cet assemblage ne peut être effectué qu'après le montage des autres composants non refroidis, c'est-à-dire à la fin, avec des soudures manuelles en reprise après l'opération de soudure à la vague des autres composants. Il y a enfin une contrainte d'accessibilité pour l'opération de vissage ou de dévissage en cas d'intervention ultérieure sur la carte et, de façon plus générale, ce type de montage classique nécessite une intervention et une manipulation manuelle assez importantes.

Un autre montage qui s'apparente au précédent consiste, toutes choses égales par ailleurs, à remplacer l'ensemble : vis, écrou, rondelle et canon isolant par un clip, en forme de M et comportant un crochet à chaque extrémité, qui est monté de façon à s'étendre parallèlement à la carte électronique, étant accroché par ses deux extrémités au dissipateur et poussant, par son milieu concave, le composant contre le dissipateur. Ce montage est soumis aux mêmes inconvénients que le premier, ou des inconvénients équivalents, mentionnés ci-dessus, et en outre, l'encombrement du clip, à mi-hauteur du dissipateur, consomme une surface non négligeable sur la carte, par projection du volume entouré par le clip et impose une hauteur limitée aux autres composants non refroidis à proximité du clip pour permettre son démontage en cas d'intervention sur le composant de puissance.

Du brevet PCT WO 90/07256, on connaît aussi un montage selon lequel plusieurs composants de puissance sont préalablement montés sur un dissipateur commun de façon assez compacte. Pour appliquer à pression les composants contre le dissipateur, sont prévus des clips dont le corps s'étend en substance selon la même orientation longitudinale que le composant, de façon à enjamber la partie haute libre du dissipateur. Ceci facilite l'accrochage des clips et minimise l'encombrement du montage. Cependant, le positionnement correct des composants et des clips par rapport au dissipateur impose à ce dernier une forme complexe. En outre, comme l'opération suivante consiste à enficher dans un support isolant commun l'ensemble solidarisé : dissipateur-composants-clips comportant de nombreuses broches, par toutes ses broches en même temps, il se pose à nouveau un problème de manipulation délicate, comme pour l'enfichage simultané dans la carte de circuit imprimé décrit ci-dessus pour les deux premiers montages de l'art antérieur cités comme exemples. Cette opération d'enfichage à plusieurs dizaines de broches parfois, requiert en effet patience et dextérité car il est difficile d'apprécier d'emblée quelles sont la ou les broches qui s'opposent généralement à la pénétration de l'ensemble.

Le problème technique que vise à résoudre l'invention est précisément d'éviter l'opération d'enfichage simultané de transistors de puissance qui nécessitent le plus souvent un dissipateur commun lorsqu'ils sont montés sur un circuit imprimé, de façon à écourter les manipulations manuelles et donc le côut du montage.

Un but de l'invention est de fournir un dispositif de fixation de composants de puissance avec dissipateur amélioré, de conception simple.

Un autre but de l'invention est de fournir un dispositif de fixation de composants de puissance avec dissipateur qui soit compact de façon à ménager de la place pour les autres composants sur la carte de circuit imprimé où ils sont montés.

Encore un autre but de l'invention est de fournir un dispositif de fixation de composants de puissance avec dissipateur sur un circuit imprimé, dont le montage commun et la réparation soient faciles et économes de main d'oeuvre.

Selon l'invention, ces buts sont atteints et les inconvénients de l'art antérieur sont atténués ou supprimés grâce au fait que le dispositif de fixation défini au premier paragraphe est remarquable en ce que le (chaque) composant est muni d'un support isolant qui lui est propre et que le (chaque) support isolant est muni, selon un plan médian, de premiers moyens de fixation et de positionnement du composant, de deuxièmes moyens de fixation et de positionnement dudit dissipateur du côté métallique du composant par rapport audit plan médian et, du côté non métallique du composant, de troisièmes moyens de fixation et de positionnement par l'une de ses extrémités, de ladite agrafe dont l'autre extrémité comporte un crochet à accrocher au dissipateur, de façon à établir un contact à pression entre le corps de l'agrafe, le composant, et le dissipateur.

La structure indiquée au paragraphe précédent ne permet pas à elle seule de faire ressortir tout l'intérêt de l'invention qui est aussi caractérisée par le procédé de montage, différent de ceux de l'art antérieur.

En effet, un procédé de montage sur une carte de circuit imprimé d'un dispositif de fixation de composants électroniques de puissance contre un dissipateur, comportant au moins un composant de puissance, un dissipateur, une agrafe et un support isolant, ce dispositif étant conforme à la structure selon l'invention indiquée ci-dessus est remarquable en ce qu'il comporte les étapes successives suivantes :
- la mise en place de chaque composant dans son support isolant propre puis l'enfichage de cet assemblage à un emplacement prévu sur la carte de circuit imprimé,
- la mise en place du dissipateur dans les deuxièmes moyens de fixation et de positionnement qui lui sont affectés, simultanément dans chaque support placé sur la carte de circuit imprimé,
- l'agrafage de chaque composant contre le dissipateur au moyen d'une agrafe,
après quoi l'ensemble des broches des composants de puissance peut être soudé, manuellement ou par soudure à la vague.

En procédant ainsi, on évite la difficile opération d'enfichage en commun de toutes les broches des composants de puissance, par inversion des opérations de montage des différents éléments.

On notera que, selon l'invention, il faut mettre en place le dissipateur commun dans tous les supports isolants individuels des composants en même temps. Mais ceci ne présente pas de difficulté de manipulation particulière, dû au fait que le dissipateur peut être constitué par une simple plaque d'aluminium, que les moyens de fixation et de positionnement peuvent être réduits à une gorge dans chaque support isolant et qu'un léger jeu latéral du support maintenu par le composant qui lui est associé, sur le circuit imprimé, permet d'obtenir immédiatement l'alignement correct contre le dissipateur lors de la solidarisation commune.

Un mode de réalisation préféré du dispositif de fixation selon l'invention est remarquable en ce que ladite agrafe est en forme de S, que ledit support isolant, de quelques millimètres d'épaisseur, comporte des premiers moyens médians de fixation et de positionnement constitués par des premiers trous pour recevoir les broches du composant, et, de chaque côté du support, une rainure qui joint les extrémités desdits premiers trous, des deuxièmes moyens de fixation et de positionnement constitués par une gorge parallèle au plan médian des premiers trous et des troisièmes moyens de fixation et de positionnement constitués par un logement central, sur le bord du support opposé à ladite gorge, conçu pour recevoir, avec effet d'accrochage par léger pivotement de l'agrafe vers le composant, un ergot d'extrémité de ladite agrafe.

De préférence, le support isolant est en polysulfure de propylène chargé de fibre de verre, moulé par injection.

De préférence, le support isolant est symétriquement muni de deuxièmes et troisièmes moyens de fixation et de positionnement sur chacune des 4 demi-faces qui s'étendent de part et d'autre des extrémités desdits premiers trous. Ceci facilite la manipulation par l'opérateur lorsqu'il monte le composant dans le support.

La description qui suit en regard des dessins annexés, le tout donné à titre d'exemple non limitatif, fera bien comprendre comment l'invention peut être réalisée.

La figure 1 représente, avec arrachements, un dispositif de fixation de composant électronique contre un dissipateur selon l'invention, monté sur une carte de circuit imprimé, la figure 1A étant une vue de profil, la figure 1B une vue en élévation et la figure 1C une vue de dessus.

La figure 2 représente un mode de réalisation du support isolant selon l'invention, vu de dessus à la figure 2A et vu de profil et en coupe à la figure 2B.

Les figures 3A et 3B représentent un deuxième mode de réalisation du support isolant selon l'invention, le mode de représentation étant le même que pour les figures 2A et 2B.

La figure 4A est une vue de profil d'une agrafe selon l'invention, et la figure 4B montre, vue en plan, l'extrémité de positionnement contre le support isolant.

La figure 5 montre, en perspective cavalière, un dispositif de fixation de plusieurs composants contre un dissipateur, monté sur une carte de circuit imprimé.

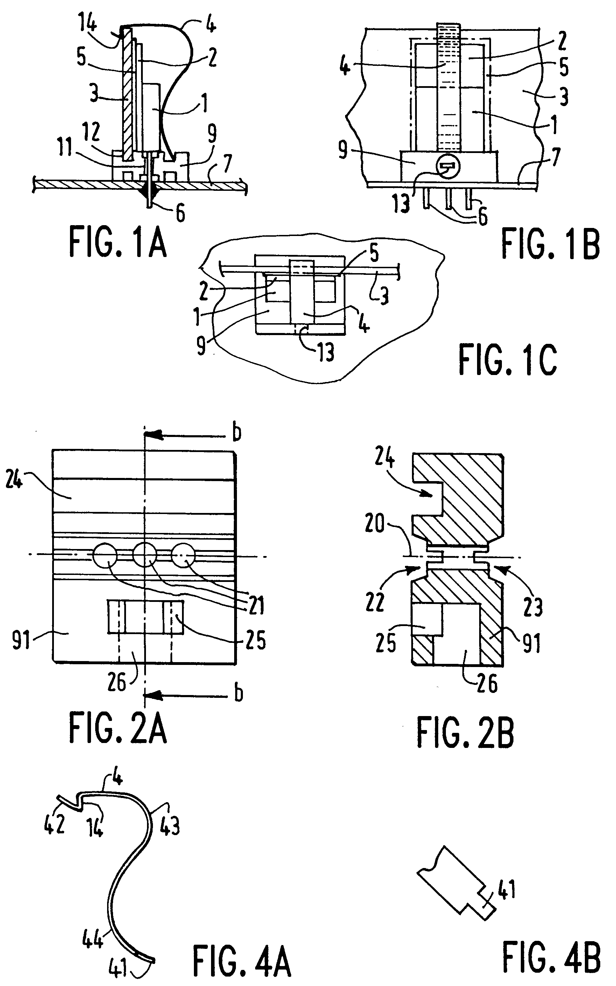

Sur la figure 1, peuvent être distingués : un composant de puissance 1 muni de sa partie métallique 2 qui est libre en partie haute, et un dissipateur 3 qui est par exemple constitué par une tôle d'aluminium d'épaisseur 2 mm et qui dépasse légèrement le haut et le bas du composant. Pour assurer une bonne communication thermique du composant vers le dissipateur, une agrafe élastique 4 presse fermement l'un contre l'autre les deux éléments précités, la pression étant appliquée au centre de la partie non métallique du composant pour assurer le meilleur contact entre métaux à l'endroit où le dégagement de chaleur engendrée par le composant est maximal. De préférence, afin d'éviter des courts-circuits électriques, un film 5 en matériau conducteur thermique mais isolant électrique, tel qu'un film silicone est interposé entre dissipateur et composant. L'assemblage précité des éléments 1 et 3 est enfiché, par les broches 6 du composant dans une carte de circuit imprimé 7, les broches y étant soudées, manuellement ou, de préférence, par soudure à la vague, l'écartement entre le bas du composant et la carte de circuit imprimé étant de l'ordre de 5 mm. Généralement, plusieurs composants tels que 1 sont ainsi fixés contre le même dissipateur 3. Pour assurer les positionnements mutuels et les fonctions décrites ci-dessus, il est prévu, selon l'invention, un support isolant 9 ainsi que l'agrafe 4. Le support 9 est propre à chaque composant de puissance. Il comporte, dans un plan médian qui est celui des broches 6 sur les figures, des premiers moyens de fixation et de positionnement du composant. Du côté métallique 2 du composant, le support 9 comporte des deuxièmes moyens de fixation et de positionnement 12, pour le dissipateur 3 et, du côté opposé, des troisièmes moyens de fixation et de positionnement 13 pour l'agrafe 4 qui est assujettie à force par l'une de ses extrémités au support et, par son autre extrémité munie d'un crochet 14, à la partie haute du dissipateur 3, soit par un bord libre comme représenté sur la figure, soit à travers une encoche ou une ouverture pratiquée dans le dissipateur (non représenté).

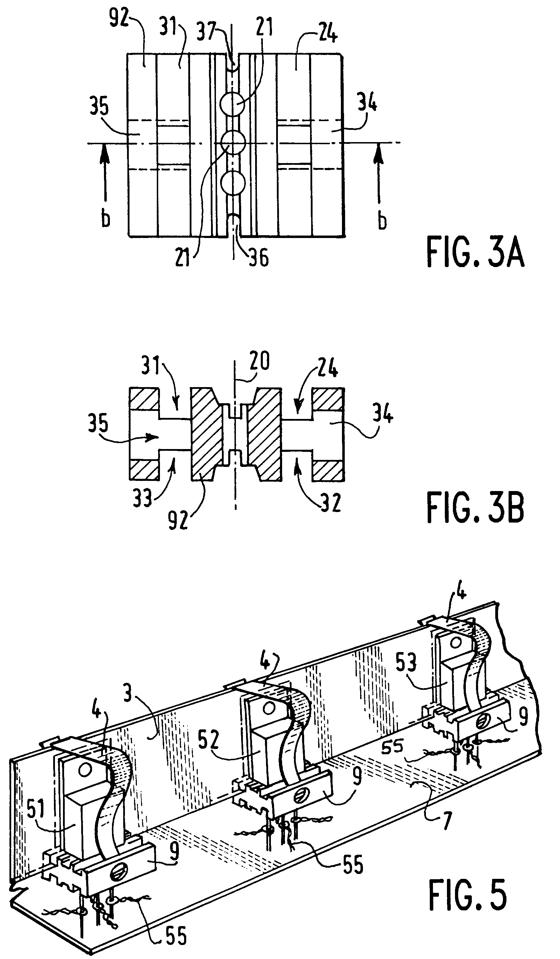

Les figures 2 et 3 montrent de façon plus détaillée deux modes de réalisation du support isolant (91 et 92, respectivement) qui revêt par exemple la forme générale d'un parallélépipède rectangle. Ce support est réalisé en une matière isolante thermique et électrique, ininflammable, de préférence en une matière plastique travaillée par moulage par injection. A cet effet, convient notamment le polysulfure de propylène, chargé avec de la fibre de verre, qui peut supporter ponctuellemènt 260°, conçu pour être assez rigide et pouvant supporter l'opération de soudure à la vague.

A la figure 2, les premiers moyens de fixation et de positionnement 11 s'étendent dans un plan médian 20 où ils sont constitués par des premiers trous tels que 21 pour le passage des broches du composant de puissance (3 en général) et par une rainure 22, respectivement 23 qui relie les extrémités des trous 21 au milieu de chaque face principale du support. La rainure 22 sert au premier guidage des broches dans les trous 21 lors de la mise en place du composant dans le support et la rainure 23, du côté destiné à être appliqué contre le circuit imprimé, à contenir des remontées de soudure éventuelles à travers les trous dans le circuit imprimé, lors de la soudure de l'extrémité des broches du composant de puissance.

Lors de l'insertion des broches dans les trous 21, il faut veiller à choisir la bonne face du support (la face de gauche à la figure 2B) et le bon côté du composant, c'est-à-dire de façon telle que la partie métallique du composant soit située au-dessus du plan médian 20 sur la figure 2. Dans une telle position (non représentée), la face métallique extérieure du composant vient à fleur d'une gorge 24 qui constitue les deuxièmes moyens de fixation et de positionnement du dissipateur. Cette gorge a par exemple 2 mm de large et 2 mm de profondeur. Du côté opposé à la gorge 24, se trouvent les troisièmes moyens de fixation et de positionement de l'agrafe 4. Ces troisièmes moyens sont par exemple constitués par un lamage de forme parallélépipédique 25 qui débouche partiellement dans un trou 26 opéré à angle droit, dans l'épaisseur du support. Lors de l'introduction (non représentée) de l'agrafe dans le trou 25, un ergot d'extrémité pénètre dans le trou 26, alors que les bords élargis de l'agrafe qui font suite à l'ergot demeurent contre l'arête inférieure externe du trou 25, ce qui procure un positionnement précis de cette extrémité à ergot de l'agrafe.

De la manière décrite ci-dessus, le composant, le dissipateur et l'agrafe qui les solidarise peuvent être positionnés avec précision entre eux, et par rapport au circuit imprimé. A cet égard, l'épaisseur du support 9 (91, 92) est de préférence comprise entre 4,5 et 6 mm.

L'un des buts de l'invention étant d'économiser du temps manuel de montage, il est particulièrement avantageux de fabriquer le support isolant 9 selon le mode de réalisation 92 de la figure 3. Cette réalisation vise à éviter le retournement du composant et/ou du support, lors de l'insertion (par ses broches) du premier dans les trous 21 du second. A cet effet, le support isolant de la figure 2 est symétriquement muni des deuxièmes et troisièmes moyens de fixation et de positionnement sur chacune des 4 demi-faces qui s'étendent de part et d'autre des extrémités des trous 21. Le lamage 25 est remplacé par une gorge 31, symétrique de la gorge 24 par rapport au plan médian 20, et deux gorges identiques sont aussi pratiquées à des emplacements homologues de la face opposée, référencées 32 et 33. Semblablement, un trou 34, respectivement 35, pratiqué au milieu de l'épaisseur du support, perpendiculairement au plan 20, débouche partiellement dans les gorges 24 et 32, respectivement 31 et 33.

On peut aussi prévoir de rendre le support isolant 9 compatible pour deux types de boîtiers différents de composants de puissance. Le support 92 de la figure 3 est adapté pour deux types de boîtiers de composants de puissance : le boîtier TO 220, au moyen des trois trous 21 ou le boitier plus large TOP3, à broches plus écartées, au moyen du trou central 21 et de deux encoches latérales 36 et 37.

Un exemple d'agrafe qui convient pour l'invention est représenté à la figure 4. Cette agrafe, qui est un ressort à lame, en forme de sinusoïde, est réalisée de préférence en acier au béryllium. Son extrémité qui se fixe contre le support isolant comporte un ergot 41 et, à l'autre extrémité, le crochet 14 est muni d'un plan incliné 42 qui permet le coulissement du crochet contre une arête du dissipateur 3, lorsqu'on appuie à force sur une partie convexe 43 du corps de l'agrafe pour réaliser l'accrochage sur le dissipateur. Pendant cette opération d'accrochage qui fait pivoter l'agrafe vers le dissipateur, l'ergot 41 pénètre plus profondément, par pivotement en sens inverse dans le trou 26 (figure 2) respectivement le trou 34 ou 35 (figure 3), de façon à empêcher une remontée de l'agrafe et son décrochage du dissipateur. Dans ce mouvement de pivotement, la partie concave 44 du corps de l'agrafe vient appuyer fortement contre le composant 1.

La figure 5 représente un dissipateur 3 contre lequel sont fixés plusieurs composants de puissance tels que 51, 52, 53, ..., l'ensemble étant solidarisé à un circuit imprimé 7 par soudure des broches des composants sous le circuit imprimé, à des pistes telles que 55. De préférence, ce montage a été effectué comme suit : chaque composant a été mis en place dans un support isolant qui lui est réservé, puis cet assemblage a été enfiché à son emplacement prévu sur la carte 7. Ensuite, le dissipateur commun a été mis en place à son tour, sans difficulté particulière, dans les deuxièmes moyens de fixation et de positionnement qui lui sont affectés dans chaque support 9 (avec interpositon d'un film silicone contre la face métallique de chaque composant). Puis, chaque composant a été agrafé contre le dissipateur au moyen d'une agrafe 4. De préférence, l'ensemble de ces opérations, qui est effectué avant ou après la pose des autres composants non refroidis, est effectué avant la soudure à la vague de l'ensemble des composants sur la carte de circuit imprimé.

Comme il est déjà connu en soi pour certains montages de l'art antérieur, l'étape de mise en place d'un dissipateur contre plusieurs composants électroniques peut comporter une étape annexe de fixation directe du dissipateur à la carte de circuit imprimé. Ceci peut être réalisé par des supports séparés du dissipateur (non représentés) qui comportent des moyens de vissage ou des broches-support qui traversent la carte de circuit imprimé. Lorsque cette mesure est adaptée à l'invention, il est avantageux de ménager un léger jeu, lors de cette fixation directe, pour éviter le pincement et le blocage des supports isolants entre le dissipateur et la carte de circuit imprimé.

Des procédés autres que le moulage par injection peuvent être envisagés pour la fabrication des supports isolants 9 (91, 92). Le support 92 de la figure 3, par exemple revêt la forme générale d'un profilé et pourrait être obtenu par étirage ou extrusion plastique, à quoi il faut ajouter des opérations d'usinage pour la réalisation des trous, lamages ou encoches, et des opérations de découpe, auquel cas, la matière utilisée peut être du makrolon.

## Revendications

1. Dispositif de fixation de composants électroniques de puissance contre un dissipateur thermique comportant l'ensemble constitué par au moins un composant de puissance, un dissipateur et une agrafe élastique de fixation à pression du composant contre le dissipateur, cette agrafe ayant même orientation longitudinale que ledit composant, et au moins un support isolant dudit ensemble, caractérisé en ce que le (chaque) composant est muni d'un support isolant qui lui est propre et que le (chaque) support isolant est muni, selon un plan médian, de premiers moyens de fixation et de positionnement du composant, de deuxièmes moyens de fixation et de positionnement dudit dissipateur du côté métallique du composant par rapport audit plan médian et, du côté non métallique du composant, de troisièmes moyens de fixation et de positionnement par l'une de ses extrémités, de ladite agrafe dont l'autre extrémité comporte un crochet à accrocher au dissipateur, de façon à établir un contact à pression entre le corps de l'agrafe, le composant, et le dissipateur.

2. Dispositif de fixation contre un dissipateur selon la revendication 1, caractérisé en ce que ladite agrafe est en forme de S, que ledit support isolant, de quelques millimètres d'épaisseur, comporte des premiers moyens médians de fixation et de positionnement constitués par des premiers trous pour recevoir les broches du composant, et, de chaque côté du support, une rainure qui joint les extrémités desdits premiers trous, des deuxièmes moyens de fixation et de positionnement constitués par une gorge parallèle au plan médian des premiers trous et des troisièmes moyens de fixation et de positionnement constitués par un logement central, sur le bord du support opposé à ladite gorge, conçu pour recevoir, avec effet d'accrochage par léger pivotement de l'agrafe vers le composant, un ergot d'extrémité de ladite agrafe.

3. Dispositif de fixation contre un dissipateur selon la revendication 1 ou 2 dans lequel un film conducteur thermique et isolant électrique est interposé entre le composant et le dissipateur.

4. Dispositif de fixation contre un dissipateur selon l'une des revendications 1 à 3, caractérisé en ce que ledit support isolant est en polysulfure de propylène chargé de fibre de verre, moulé par injection.

5. Dispositif de fixation contre un dissipateur selon l'une des revendications 1 à 4, caractérisé en ce que ledit support isolant est symétriquement muni desdits deuxièmes et troisièmes moyens de fixation et de positionnement sur chacune des 4 demi-faces qui s'étendent de part et d'autre des extrémités desdits premiers trous.

6. Procédé de montage sur une carte de circuit imprimé d'un dispositif de fixation de composants électroniques de puissance contre un dissipateur, comportant au moins un composant de puissance, un dissipateur, une agrafe et un support isolant, ce dispositif étant conforme à l'une des revendications 1 à 5, caractérisé en ce qu'il comporte les étapes successives suivantes :
- la mise en place de chaque composant dans son support isolant propre puis l'enfichage de cet assemblage à un emplacement prévu sur la carte de circuit imprimé,
- la mise en place du dissipateur dans les deuxièmes moyens de fixation et de positionnement qui lui sont affectés, simultanément dans chaque support placé sur la carte de circuit imprimé,
- l'agrafage de chaque composant contre le dissipateur au moyen d'une agrafe,
après quoi l'ensemble des broches des composants de puissance peut être soudé, manuellement ou par soudure à la vague.

7. Procédé de montage selon la revendication 6 selon lequel l'étape de mise en place du dissipateur comporte une étape annexe de fixation directe du dissipateur à la carte de circuit imprimé, par vissage, ou soudage au moyen de broches-support qui traversent le circuit imprimé, un léger jeu étant ménagé, lors de cette fixation, pour éviter le pincement des supports entre le dissipateur et la carte de circuit imprimé.
